# EUROPEAN PATENT SPECIFICATION

(11) **EP 0 518 591 B1**
(45) Date of publication and mention of the grant of the patent: **14.02.1996**
(21) Application number: 92305227.8
(22) Date of filing: 08.06.1992
(51) Int. Cl.: C23C 16/26, C23C 16/00

(54) **Method for producing articles by chemical vapor deposition and the articles produced therefrom**
Verfahren zum Herstellen von Formkörpern mittels CVD und daraus hergestellte Formkörper
Procédé de production des objects par dépôt chimique en phase vapeur et les objets produits

(30) Priority: 12.06.1991 US 713499
(43) Date of publication of application: 16.12.1992
(73) Proprietor: GENERAL ELECTRIC COMPANY, Schenectady, NY 12345 (US)
(72) Inventor: Mowrey, William Lester, Burnt Hills, New York 12027 (US); Young, Sidney Perham, Scotia, New York 12302 (US); Anthony, Thomas Richard, Schenectady, New York 12309 (US); Woodruff, David Winfield, Clifton Park, New York 12065 (US); Iacovangelo, Charles Dominic, Schenectady, New York 12309 (US); Ettinger, Robert Helmut, Schenectady, New York 12303 (US)
(74) Representative: Pratt, Richard Wilson

(56) References cited:
- EP-A- 0 013 492
- EP-A- 0 417 924
- GB-A- 342 648
- US-A- 3 318 724
- PATENT ABSTRACTS OF JAPAN vol. 13, no. 388 (C-630)(3736) 28 August 1989 & JP-A-1 138 110
- IBM TECHNICAL DISCLOSURE BULLENTIN. vol. 33, no. 3B, 1 August 1990, ARMONK, NY, USA. pages 416 - 417; 'NOVEL METHOD TO INCREASE NOZZLE LIFE AND REDUCING NOZZLE SIZE ON WATER JET CUTTING TOOL'
- PATENT ABSTRACTS OF JAPAN vol. 15, no. 357 (C-866)(4885) 10 September 1991 & JP-A-3 141 110

## Description

The present invention generally relates to an improved method used for producing articles by chemical vapor deposition and more particularly concerns an improved support mandrel used in producing water-jet mixing tubes made from diamond.

Diamond is an allotrope of carbon exhibiting a crystallographic network comprising exclusively of covalently bonded, aliphatic *sp³* hybridized carbon atoms arranged tetrahedrally with a uniform distance of 1.545 Å between atoms. Diamond is extremely hard having a Mohs hardness of 10. It exhibits four times the thermal conductivity of copper and it is electrically insulating. Its hardness and thermal properties are but two of the characteristics that make diamond useful in a variety of industrial components. Initially non-gem quality natural diamonds were used in a variety of abrasive applications but with the invention of synthetic diamonds by high pressure/high temperature techniques, a spectrum of additional products have found favor in the marketplace. However, the requirement of high pressure and high temperature has been a limitation in preventing extensive usage of synthetic diamonds.

Recent industrial efforts directed toward the growth of diamonds at low pressures has dramatically increased the feasibility of using diamonds in various industrial applications. Low pressure growth of diamond has been dubbed "chemical vapor deposition" or "CVD" in the field. In the CVD process diamonds are grown at low pressures from hydrocarbon gases in the presence of atomic hydrogen. Many methods have been disclosed for growing diamonds metastably and generally these methods differ from each other by the way in which atomic hydrogen, a key reactant, is generated and transported within the system. For a general summary of various diamond deposition methods including CVD methods, reference is made to Bachmann, et al., Diamond Thin Films, Chemical & Engineering News, 67(20), 24-39 (May 15, 1989), to Bhat, D., Chemical Vapor Deposition, Surface Modification Technologies, An Engineer's Guide, edited by Sudarshan, T.,1989 Edition, Marcel Dekker, Inc., New York, New York, pages 141-218, and to Hocking, M., Vasantasree, V., and Sidky, P., Chemical Vapour Deposition, Metallic & Ceramic Coatings; Production, High Temperature Properties & Application, Longman Scientific & Technical Group, England (U.K.) copublished with John Wiley & Sons, New York, New York, pages 103-172.

When a free standing diamond film for example having a funnel shape is desired, it is very cumbersome and invariably impractical to prepare a substrate on which such a film could be deposited. In one of the prior art methods a funnel shape is machined from a tubular shape. However it is very difficult and expensive to machine material such as diamond to the degree of precision required in high pressure water jet cutting systems. For a general summary of various hydro-machining methods including water jet cutting methods, reference is made to a special report on Wet Grit, Abrasive Waterjets, American Machinist, October 1989, Penton Publishing, Inc., Cleveland, Ohio, pages 84 -97 and to Guha, J., High-Pressure waterjet Cutting: An Introduction, Ceramic Bulletin, Vol. 69, No.6, 1990, pages 1027-1029.

Patents Abstracts of Japan, Vol. 3, No. 388 (C-630) [3736], 28.08.1989 (an abstract of JP-A-1138110) describes a pipe made of diamond and production thereof of this Japanese patent application as follows:

PURPOSE: To easily obtain a diamond pipe composed of a film of aggregated crystals having specific particle diameter, by applying a CVD diamond film on the surface of a columnar base material and removing only the base material from the product.

CONSTITUTION: A CVD diamond film is formed on the surface of a heat-resistant base having a columnar outer surface and the base is removed, e.g. by dissolution to obtain a pipe composed of a thin film of aggregated diamond crystals having particle diameter of 0.1 - 800µm.

The present invention is as claimed in the claims.

The present invention is directed to an improved method of producing a water-jet mixing tube; comprising workforming a substrate to form a surface having a desired shape thereon, depositing a support member material on the surface to form a support member thereon, separating the support member from the substrate, chemical vapor depositing an article material on the support member to form the article thereon, and separating the article from the support member.

Other advantages of the invention will become apparent upon reading the following detailed description and appended claims, and upon reference to the accompanying drawings.

For a more complete understanding of this invention reference should now be had to the embodiments illustrated in greater detail in the accompanying drawings and described below by way of examples of the invention.

Figure 1A and Figure 1B illustrate an isometric cross sectional view of a substrate during the workforming steps of the preferred embodiment.

Figure 1C illustrates the isometric cross sectional view of the substrate during the workforming step of another embodiment.

Figure 1D illustrates the isometric cross sectional view of the substrate after a chemical vapor deposition step of a support member on the substrate.

Figure 1E illustrates the isometric cross sectional view of the support member after separation of the substrate from the support member.

Figure 1F illustrates the isometric cross sectional view of the support member after a chemical vapor deposition step of an article material on the support member.

Figure 1G illustrates the isometric cross sectional view of the article after the separation of the support member from the article.

Figure 2 illustrates the isometric cross sectional view of another embodiment of the article.

Figure 3 illustrates the isometric cross sectional view of yet another embodiment of the article.

While the invention will be described in connection with a preferred embodiment, it will be understood that it is not intended to limit the invention to that embodiment. On the contrary, it is intended to cover all alternatives, modifications and equivalents as may be included within the scope of the invention as defined by the appended claims.

In recent years, the synthesis of free standing articles made from diamond films has been extensively researched. One of the major problems associated with producing such free standing articles is the method by which the underlying substrate is produced.

Turning now to Figures 1A through 1G, there is shown a method by which the free standing article made from an article material such as diamond, is produced through the steps of the preferred embodiment.

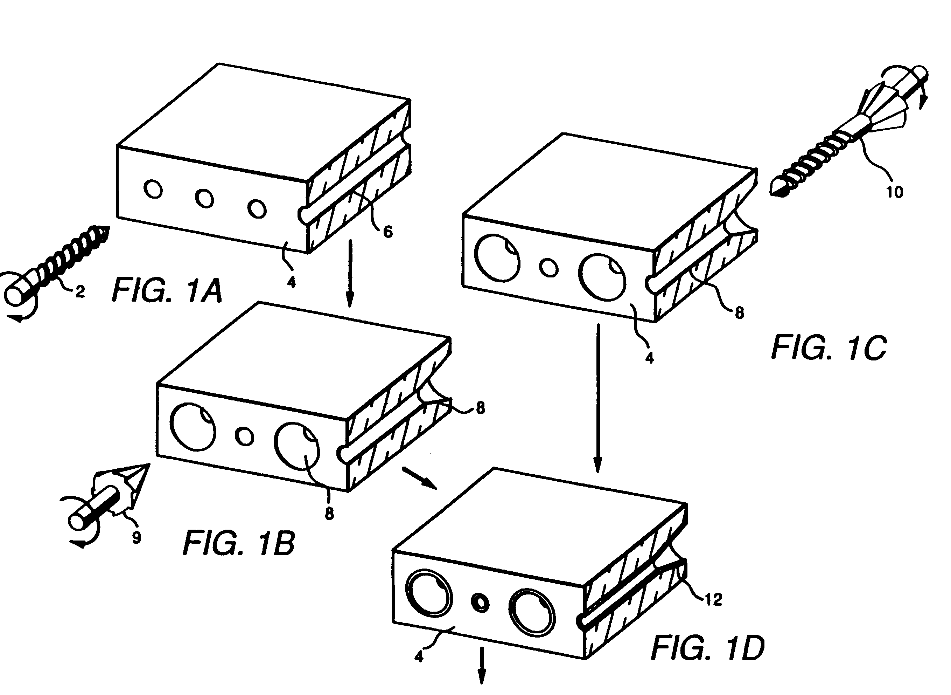

In Figure 1A there is shown the workforming step such as drilling performed by a drill **2** on a substrate **4** for producing a substantially straight bore **6**, shown in the cross section. The term "workforming" is defined as a method by which substrate **4** may be shaped, machined, or modified in a predetermined manner. In Figure 1B bore **6** may be modified by a spade drill **9** to form a surface **8** having a desired shape, such as a funnel shape, on substrate **4**. Alternatively, as shown in Figure 1C, surface **8** may be workformed on substrate **4** by a combination drill **10**, thereby reducing the number of steps required to form the desired shape on substrate **4**. However, it should be apparent to those skilled in the art to use some other workforming steps, such as milling, grinding, electrical discharge machining, boring, shaping, honing, molding or diecasting to form the desired surface **8** on substrate **4**. If preferred, as shown in Figures 1B or 1C a plurality of surfaces **8** having the desired shapes may be workformed on substrate **4** to increase rate of producing the free standing articles. Substrate **4** may be made of a workformable and thermally stable material, such as an allotrope of carbon in a graphitic form or a stainless steel comprising at least 12% of chromium. However some other thermally stable material may be also used. Once the workforming step is completed, surface **8** may be cleaned with cleaning means, such as a high pressure air jet to remove debris formed during the workforming step.

Upon completion of the workforming step, a support member material is conventionally deposited on substrate **4**. The deposition of the support member material can be achieved by well known methods of the art for example by a CVD process. The process of the preferred embodiment is the CVD process for chemical vapor deposition of the support member material on surface **8** to form a support member **12**, shown in Figure 1D. The support member material suitable for the CVD process may be a thermally stable metal, such as tungsten, molybdenum, rhenium, niobium, tantalum, zirconium, hafnium, nickel, vanadium, chromium or titanium. Tungsten is preferred. During the CVD process of the preferred embodiment, not shown, a vapor of a compound of the support member material, preferably tungsten hexafluoride, is preferably entrapped in hydrogen gas to form a first gaseous mixture which may be then conveyed into a CVD reaction chamber. The volumetric ratio of hydrogen to the metal compound vapor may be maintained at about 3 : 1 to about 30 : 1, preferably at about 7.5 : 1. The metal compound vapor is preferably formed by surrounding a container of the metal compound with a heat jacket maintained at a temperature sufficient to vaporize the metal compound. The first gaseous mixture may be diluted with an inert gas, such as argon.

The first mixture is preferably energized to degrade into fragments by heating means, such as radio frequency (RF) heating means exemplified by a RF coil proximately positioned near substrate **4**. The RF field generates heat in substrate **4** and by regulating the intensity of the radio frequency and the distance between the RF coil and substrate **4**, the temperature of substrate **4** may be adjusted to a desired level. The temperature of substrate **4** may be maintained at about 250 °C to about 800 °C, preferably at about 600 °C. The fragments of the first gaseous mixture are adsorbed on surface **8** of substrate **4** having the desired shape. The aforementioned fragments then decompose to form a film, containing support member **12** shown in Figure 1D, whose surface substantially conforms to surface **8** of substrate **4**. Preferably support member **12** is a hollow mandrel having a thickness of about 80 to about 110 micrometers. However to those skilled in the art it will be apparent to adjust the thickness of support member **12**, shown in Figure 1D, to a thickness sufficient to withstand the requirements of the CVD process.

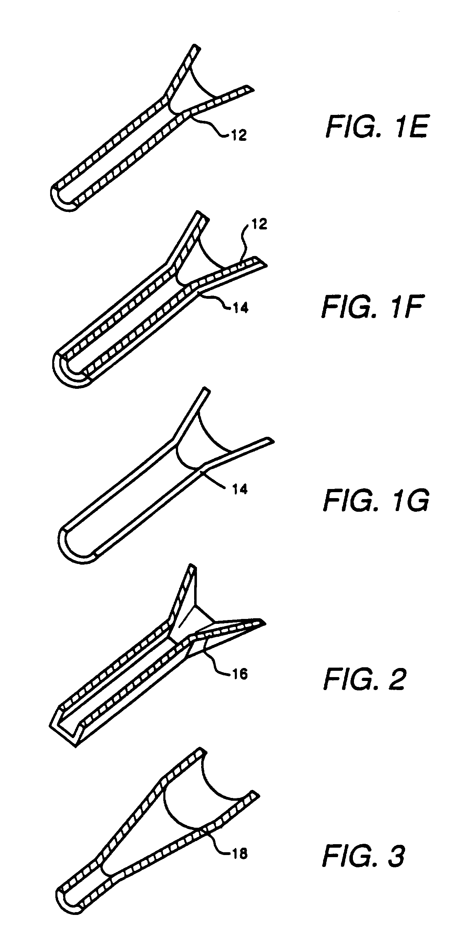

A desired portion of the film that forms support member **12** may be detached by cutting means such as a Nd-YAG, Q-switched laser from the remaining film. Support member **12** may then be separated from substrate **4**. One of the methods of separation is by using a compatible release agent, such as boron nitride or silica, applied on surface **8** of substrate **4** prior to the chemical vapor deposition of the support member material. Another method of separation is by selecting the support member material having higher coefficient of thermal expansion than substrate **4** so that when support member **12** cools, it contracts and detaches away from substrate **4**. Yet another method of separation is by physically forcing support member **12** away from substrate **4**. The separation of support member **12** through thermal contraction is preferred. Figure 1E shows support member **12** after it is separated from the film and substrate **4**.

Support member **12** is then exposed to a conventional CVD process, not shown, for chemical vapor deposition of the article material on support member **12** to form a free standing article **14**, shown in Figure 1D. The article material may be carbon, silicon, germanium, boron, aluminum, zirconium, tungsten, titanium or molybdenum. The preferred article material is an allotrope of carbon in the form of diamond. During the CVD process a compound of the article material, preferably methane, may be entrapped in hydrogen gas to form a second gaseous mixture which may be then conveyed into a CVD reaction chamber. It will be obvious to those skilled in the art to either use the same CVD reaction chamber for depositing the support member and the article materials or to use different CVD reaction chambers for depositing the support member and the article materials. The second gaseous mixture may comprise about 1% to about 2%, preferably about 1.5% by volume of the compound of the article material, the rest being hydrogen. The second gaseous mixture may be diluted with an inert gas, such as argon. The rate of diamond deposition may be enhanced by improving the nucleation of diamond on support member **12** during the CVD process. The preferred method of improving the diamond nucleation comprises rubbing a surface of support member **12** on which diamond is deposited with a hydrocarbon oil based paste of diamond dust before the surface is exposed to the deposition of diamond by the CVD process. The particle size of diamond dust in the paste may be about 0.5 to about 1 micrometre (micron) and the surface of support member **12** may be rubbed for about 2 to about 5 minutes. Another method of improving the diamond nucleation, for example, comprises contacting for about 5 minutes, the surface of support member **12** with an agitated suspension in alkanol of diamond particles having a size of about one micrometre (micron). An ultrasonically agitated suspension of diamond particles in ethyl alcohol is preferred.

The second mixture may be energized to degrade into fragments by heating means, such as passing the second mixture over a non-reactive filament, such as tungsten, sufficiently heated to thermally degrade the second mixture into fragments. The filament may be resistively heated to generate heat. If desired, a plurality of filaments may be employed. The rate of deposition of the article material on support member **12** may be controlled by regulating the electrical power applied to the filament and by adjusting the distance between the filament and support member **12**. The temperature of filament may be maintained at about 1900 °C to about 2400 °C, preferably at about 2150 °C. The surface of support member **12** adsorbs fragments of the second gaseous mixture which then decomposes on the surface of support member **12** to form a film containing article **14**. Support member **12** may be supported to prevent its distortion during adsorption of fragments by the surface of support member **12**. Preferably support member **12** may be supported by an elongated member, such as a rod.

A desired portion of the film that contains article **14** is separated by cutting means such as a Nd-YAG, Q-switched laser, not shown, from the remaining film. Figure 1F shows support member **12** having article **14** deposited thereon. Article **14** formed on the surface of support member **12** is then separated from support member **12**. One of the methods of separation comprises etching away support member **12** by an etching bath and thereby leaving a free standing article **14** shown in Figure 1G. Support member **12** having article **14** formed thereon may be placed in the etching bath which may be then agitated to etch away support member **12**. One of the etching baths suitable for use in the present invention comprises a mixture in equal parts of hydrochloric acid having a concentration of about 36% to about 38% by weight in water, nitric acid having a concentration of about 69% to about 71% by weight in water and hydrofluoric acid having a concentration of about 49% to about 51% by weight in water. The etching bath may be agitated by ultrasonic means for dislodging the bubbles formed on support member **12** during the etching action. Another method of separation of support member **12** from article **14** comprises using a support member material, such as niobium which is substantially less adherent to the article material such as diamond than to the support material such as tungsten. Support member **12** made of niobium can be easily separated from article **14** and then used repeatedly to form article **14** on it.

In another embodiment of the present invention support member **12**, shown in figure 1D, is deposited on substrate **4** by an electroforming process. The electroforming process is defined as an electroless, electrolytic or electroless followed by electrolytic plating process by which the support member material is plated or deposited on substrate **4** to form support member **12**. Preferably support member **12** prepared by the electroforming process comprises an electrolessly deposited first metal layer followed by an electrolytically deposited second metal layer.

Substrates suitable for the electroless plating process may be electrically conductive substrates made from metals and their alloys, such as aluminum or electrically insulating substrates made from polymers, such as polystyrene or polycarbonate. In the case of a polymer substrate, such as a polycarbonate substrate it is often necessary to activate a substrate surface before the surface can be electrolessly plated. Activation of the polymer substrate for plating purposes can be achieved by well known methods of the art. For example, the substrate may be contacted with an acid solution of a precious metal, such as palladium chloride in hydrochloric acid, for a period of time sufficient to cause catalytic activation of the polymer substrate surface.

Activation and plating processes suitable for the present invention are also described in W.T. Grubb et al, European No. EP 272,420, as well as in U.S. Patents 3,011,920 and 3,841,881, issued to Shipley and Feldstein et al, respectively. A water rinse generally follows the activation step.

After surface activation and rinsing, electroless plating can be undertaken to form the first metal layer. Illustrative metals used to form the first metal layer include zinc, silver, palladium, copper, nickel, cobalt, chromium, molybdenum and various possible combinations thereof. The term "combinations" is defined to mean multiple layers of various metals deposited on the polymer surface in any desired order. Electroless baths are well-known in the art and are generally described in the Kirk-Othmer Encyclopedia of Chemical Technology, 3rd Edition, Volume 8.

The selection of a particular bath or electroless plating process is not critical to the present invention. The contents of the bath and the particular plating parameters, e.g., temperature, pH, and immersion time, will of course depend on the particular polymer serving as the substrate, and also upon the particular metal being deposited thereon. Those having ordinary skill in the plating art will be able to determine the most appropriate plating procedure for a particular situation.

Although the aforementioned electroless plating is the preferred application method for the first metal layer, electrolytic plating may be also used. However electrolytic plating also called electroplating is the preferred application method for the second metal layer.

Electroplating baths are well-known in the art and are described, for example, in U.S. Patent 4,555,315, although the particular electroplating bath used is not critical to the present invention. The choice of course depends in part on the particular metal being deposited. However the metal forming the second metal layer should have a melting point of at least 1000 °C to withstand the typical CVD diamond deposition temperatures. Illustrative metals used to form the second metal layer include copper, palladium, nickel, cobalt, chromium, niobium, titanium, tantalum, molybdenum and various possible combinations thereof. Furthermore, those skilled in the art appreciate that the particular bath contents will depend upon some of the factors considered for the electroless deposition of metal described above. A description of baths for plating copper or various other metals is given in the Kirk-Othmer reference described above, in Vol. 8, beginning on page 826.

Another embodiment of the present invention is illustrated in Figure 2. A hexagonal shaped funnel **16** having a rectangular spout is disclosed.

Yet another embodiment of the present invention is illustrated in Figure 3. A cone shaped funnel **18** having a cylindrical extension and a rectangular spout is disclosed.

The articles produced by the method of the present invention may be used, for example, in producing fluid nozzles, water-jet mixing tubes, heat sinks for integrated circuit chips, wire guides for electrical discharge machines, thread guides for textile machinery and test tubes.

The present invention will be further understood from the illustration of a specific example which follows. This example is intended for illustrative purposes only and should not be construed as limitation upon the broadest aspects of the invention.

### Example

The process in the example set forth below was carried out by the steps described above and illustrated in Figure 1A through 1F.

A substrate made of graphite was a 10 cm (4 inch) diameter by 2.5 cm (1 inch) thick disc. 48 funnel shapes drilled in the substrate had a total surface area of 191 square centimeters. The substrate then placed in the first CVD reaction chamber, was provided with RF heat to raise its temperature to 600 °C.

Tungsten hexafluoride (WF₆) liquid was vaporized at 35 °C to provide a steady flow regulated at a flow rate of 350 standard cubic centimeters per hour, hereinafter SCCM. Tungsten hexafluoride was mixed with hydrogen at a flow rate of 6000 SCCM to form the first mixture, then conveyed into the CVD reaction chamber maintained at 13.5 x 10⁻³ kg/cm (10 Torr) pressure. The first mixture was energized by the heat from the substrate to degrade into fragments which were then adsorbed by the surface of the substrate containing the funnel shapes to decompose into tungsten. Tungsten was deposited at a deposition rate of 1.7 micrometers per minute for 60 minutes to produce a tungsten film of 102 micrometers on the surface of the substrate.

The funnel shaped hollow tungsten mandrels formed on the surface of the substrate were separated from the rest of the tungsten film by means of a Nd-YAG, Q-switched laser, Model No. 4024 made by U.S. Laser Corporation, Waldwick, New Jersey and then forced out of the funnel shapes in the substrate.

The mandrels were vertically strung on tungsten wires tautly held under tension and placed in the CVD reaction chamber. Eleven vertical rows of tungsten filaments having a height of 28 cms (11 inches) were interspaced with ten rows of mandrels having a height of 25.4 cm (10 inches), each row spaced from the other at about 1 centimeter.

The tungsten filaments were heated to 2150 °C and the second mixture comprising 1.5% by volume of methane and 98.5% by volume of hydrogen was passed over the heated filaments at a rate of 2 standard liters per minute for 3 weeks. The second reaction chamber was maintained at 13.5 x 10⁻³ Kg/cm (10 Torr) and diamond was deposited to a thickness of 1 millimeter. The mandrels containing the funnel shaped diamond water-jet mixing tubes were separated from the rest of the diamond film by a Nd-YAG, Q-switched laser, Model No. 4024 made by U.S. Laser Corporation, Waldwick, New Jersey and then the mandrels were etched away by exposing them to the etching bath of the preferred embodiment for 10 minutes to form the free standing funnel shaped diamond water-jet mixing tubes. The mixing tubes were 7.62 centimeters long having an inner diameter of 0.102 centimeters and a funnel diameter of 0.457 centimeters.

While particular embodiments of the invention have been shown, it will be understood, of course, that the invention is not limited thereto since modifications may be made by those skilled in the art, particularly in light of the foregoing teachings. It is, therefore, contemplated by the appended claims to cover any such modifications as incorporate those features which constitute the essential features of these improvements within the scope of the invention.

## Claims

1. A method of producing a water-jet mixing tube comprising:
workforming a substrate to form a substantially straight bore therein;
depositing a mandrel material on the surface of said bore to form a hollow mandrel thereon;
separating said mandrel from said substrate;
depositing diamond on said mandrel by chemical vapor deposition to form said mixing tube thereon; and
separating said mixing tube from said mandrel.

2. A method according to claim 1 wherein the workforming step comprises drilling.

3. A method according to claim 1 wherein the mandrel material is deposited by chemical vapor deposition.

4. A method according to claim 1 wherein the mandrel comprises tungsten, molybdenum, rhenium, niobium, tantalum, zirconium, hafnium, nickel, vanadium, chromium or titanium.

5. A method according to claim 1 wherein the mandrel material is deposited by electroforming.

6. A method according to claim 5 wherein the electroforming step comprises:
depositing a first metal layer on said substrate by electroless deposition, and
electrolytically depositing a second metal layer on said first metal layer.

7. The method according to claim 6 wherein said substrate is polycarbonate.

8. The method according to claim 6 wherein said first metal layer is zinc and said second metal layer is chromium.

9. A method according to claim 1 wherein the step of separating said article from said mandrel comprises:
placing said mandrel having said article thereon in an etching bath; and
agitating said etching bath to etch away said mandrel.

10. The method according to claim 9 wherein said etching bath comprises a mixture in equal parts of hydrochloric acid having a concentration of about 36% to about 38% by weight in water, nitric acid having a concentration of about 69% to about 71% by weight in water and hydrofluoric acid having a concentration of about 49% to about 51% by weight in water.

11. A method according to claim 9 wherein said etching bath is ultrasonically agitated to dislodge bubbles formed on said mandrel during the etching action.

12. A method of producing a funnel shaped diamond water-jet mixing tube comprising:
workforming a thermally stable substrate to form a funnel shape therein;
depositing a layer of a mandrel material selected from the group consisting of tungsten, molybdenum, rhenium, niobium, tantalum, zirconium, hafnium, nickel, vanadium, chromium and titanium on said funnel shape by chemical vapor deposition to form a hollow, funnel shaped mandrel thereon;
separating said mandrel from said substrate;
depositing a diamond layer on said mandrel by chemical vapor deposition; and
etching away said mandrel.

13. A method of producing a funnel shaped diamond water-jet mixing tube comprising:
workforming a thermally stable substrate to form a funnel shape therein;
depositing a first layer of at least one metal selected from the group consisting of zinc, silver, palladium, copper, nickel, cobalt, molybdenum and chromium on said funnel shape;
electrolytically depositing on said first layer a second layer of at least one metal selected from the group consisting of palladium, copper, nickel, cobalt, molybdenum, chromium, niobium, tantalum and titanium to form a hollow, funnel shaped mandrel;
separating said mandrel consisting of said first and second layers from said substrate;
depositing a diamond layer on said mandrel by chemical vapor deposition; and
etching away said mandrel.

## Patentansprüche

1. Verfahren zum Herstellen eines Wasserstrahl-Mischrohres, umfassend:
Bearbeiten eines Substrates zur Bildung einer im wesentlichen geraden Bohrung darin;
Abscheiden eines Dornmaterials auf der Oberfläche der Bohrung zur Bildung eines hohlen Dornes darauf;
Trennen des Dornes vom Substrat;
Abscheiden von Diamant auf dem Dorn durch chemisches Bedampfen zur Bildung des Mischrohres darauf und
Trennen des Mischrohres vom Dorn.

2. Verfahren nach Anspruch 1, worin das Bearbeiten ein Bohren umfaßt.

3. Verfahren nach Anspruch 1, worin das Dornmaterial durch chemisches Bedampfen abgeschieden wird.

4. Verfahren nach Anspruch 1, worin der Dorn Wolfram, Molybdän, Rhenium, Niob, Tantal, Zirkonium, Hafnium, Nickel, Vanadium, Chrom oder Titan umfaßt.

5. Verfahren nach Anspruch 1, worin das Dornmaterial durch Galvanoplastik abgeschieden wird.

6. Verfahren nach Anspruch 5, worin die Galvanoplastik-Stufe umfaßt:
Abscheiden einer ersten Metallschicht auf dem Substrat durch stromlose Abscheidung und
elektrolytisches Abscheiden einer zweiten Metallschicht auf der ersten Metallschicht.

7. Verfahren nach Anspruch 6, worin das Substrat Polycarbonat ist.

8. Verfahren nach Anspruch 6, worin die erste Metallschicht Zink und die zweite Metallschicht Chrom ist.

9. Verfahren nach Anspruch 1, worin die Stufe des Trennens des Gegenstandes vom Dorn umfaßt:
Anordnen des Dornes mit dem darauf befindlichen Gegenstand in einem Ätzbad und
Rühren des Ätzbades, um den Dorn abzuätzen.

10. Verfahren nach Anspruch 9, worin das Ätzbad eine Mischung gleicher Teile von Chlorwasserstoffsäure mit einer Konzentration von etwa 36 bis etwa 38 Gew.-% in Wasser, Salpetersäure mit einer Konzentration von etwa 69 bis etwa 71 Gew.-% in Wasser und Fluorwasserstoffsäure mit einer Konzentration von etwa 49 bis etwa 51 Gew.-% in Wasser umfaßt.

11. Verfahren nach Anspruch 9, worin das Ätzbad ultraschall-gerührt wird, um während des Ätzens auf dem Dorn gebildete Blasen zu entfernen.

12. Verfahren zum Herstellen eines trichterförmigen Wasserstrahl-Mischrohres aus Diamant, umfassend:
Bearbeiten eines thermisch stabilen Substrates zur Bildung eines Trichters darin;
Abscheiden einer Schicht aus einem Dornmaterial, ausgewählt aus der Gruppe bestehend aus Wolfram, Molybdän, Rhenium, Niob, Tantal, Zirkonium, Hafnium, Nikkel, Vanadium, Chrom und Titan, auf dem Trichter durch chemisches Bedampfen, um einen hohlen, trichterförmigen Dorn darauf zu bilden;
Trennen des Dornes von dem Substrat;
Abscheiden einer Diamantschicht auf dem Dorn durch chemisches Bedampfen und
Wegätzen des Dornes.

13. Verfahren zum Herstellen eines trichterförmigen Wasserstrahl-Mischrohres aus Diamant, umfassend:
Bearbeiten eines thermisch stabilen Substrates zur Bildung eines Trichters darin;
Abscheiden einer ersten Schicht aus mindestens einem Metall, ausgewählt aus der Gruppe bestehend aus Zink, Silber, Palladium, Kupfer, Nickel, Cobalt, Molybdän und Chrom, auf dem Trichter;
elektrolytisches Abscheiden einer zweiten Schicht aus mindestens einem Metall, ausgewählt aus der Gruppe bestehend aus Palladium, Kupfer, Nickel, Cobalt, Molybdän, Chrom, Niob, Tantal und Titan, auf der ersten Schicht, um einen hohlen, trichterförmigen Dorn zu bilden;
Trennen des aus der ersten und zweiten Schicht bestehenden Dornes vom Substrat;
Abscheiden einer Diamantschicht auf dem Dorn durch chemisches Bedampfen und
Wegätzen des Dornes.

## Revendications

1. Procédé de fabrication d'un tube de mélangeage de jets d'eau, qui comprend les étapes consistant à :
- usiner un substrat pour y former un trou sensiblement rectiligne,
- déposer un matériau de mandrin sur la surface dudit trou afin d'y former un mandrin creux,
- séparer ledit mandrin dudit substrat,
- déposer du diamant sur ledit mandrin par dépôt chimique à partir d'une phase gazeuse afin de former ledit tube de mélangeage sur ce mandrin, et
- séparer ledit tube de mélange dudit mandrin.

2. Procédé selon la revendication 1, dans lequel l'étape d'usinage comprend une étape de perçage.

3. Procédé selon la revendication 1, dans lequel le matériau de mandrin est déposé par dépôt chimique à partir d'une phase gazeuse.

4. Procédé selon la revendication 1, dans lequel le mandrin contient du tungstène, du molybdène, du rhénium, du niobium, du tantale, du zirconium, du hafnium, du nickel, du vanadium, du chrome ou du titane.

5. Procédé selon la revendication 1, dans lequel le matériau de mandrin est déposé par électroformage.

6. Procédé selon la revendication 5, dans lequel l'étape d'électroformage comprend :
- le dépôt d'une première couche de métal sur ledit substrat par un procédé non électrolytique, et
- le dépôt électrolytique d'une seconde couche de métal sur ladite première couche de métal.

7. Procédé selon la revendication 6, dans lequel ledit substrat est du polycarbonate.

8. Procédé selon la revendication 6, dans lequel ladite première couche de métal est du zinc et ladite seconde couche de métal est du chrome.

9. Procédé selon la revendication 1, dans lequel l'étape de séparation dudit objet et dudit mandrin comprend :
- la mise en place dudit mandrin, sur lequel se trouve ledit objet, dans un bain d'attaque chimique, et
- l'agitation dudit bain d'attaque chimique pour éliminer ledit mandrin.

10. Procédé selon la revendication 9, dans lequel ledit bain d'attaque chimique comprend un mélange en parties égales d'une solution dans l'eau d'acide chlorhydrique ayant une concentration d'environ 36 à 38% en poids, d'une solution dans l'eau d'acide nitrique ayant une concentration d'environ 69 à 71% en poids et d'une solution dans l'eau d'acide fluorhydrique ayant une concentration d'environ 49 à 51% en poids.

11. Procédé selon la revendication 9, dans lequel ledit bain d'attaque chimique est agité par ultrasons pour éliminer les bulles formées sur ledit mandrin pendant ladite attaque chimique.

12. Procédé de fabrication d'un tube de mélangeage de jets d'eau, en diamant et en forme d'entonnoir, qui comprend les étapes consistant à :
- usiner un substrat thermiquement stable pour y former une forme d'entonnoir,
- déposer sur ladite forme d'entonnoir une couche de matériau de mandrin choisi dans le groupe formé par le tungstène, le molybdène, le rhénium, le niobium, le tantale, le zirconium, le hafnium, le nickel, le vanadium, le chrome et le titane, par dépôt chimique à partir d'une phase gazeuse, pour y former un mandrin creux, en forme d'entonnoir,
- séparer ledit mandrin dudit substrat,
- déposer une couche de diamant sur ledit mandrin par dépôt chimique à partir d'une phase gazeuse, et
- enlever ledit mandrin par attaque chimique.

13. Procédé de fabrication d'un tube de mélangeage de jets d'eau, en diamant et en forme d'entonnoir, qui comprend les étapes consistant à :
- usiner un substrat thermiquement stable pour y former une forme d'entonnoir,
- déposer sur ladite forme d'entonnoir une première couche d'au moins un métal choisi dans le groupe formé par le zinc, l'argent, le palladium, le cuivre, le nickel, le cobalt, le molybdène et le chrome,
- déposer par voie électrolytique sur ladite première couche une seconde couche d'au moins un métal choisi dans le groupe formé par le palladium, le cuivre, le nickel, le cobalt, le molybdène, le chrome, le niobium, le tantale et le titane, pour former un mandrin creux, en forme d'entonnoir,
- séparer dudit substrat ledit mandrin constitué desdites première et seconde couches,
- déposer par dépôt chimique à partir d'une phase gazeuse une couche de diamant sur ledit mandrin, et
- enlever ledit mandrin par attaque chimique.
